# EUROPÄISCHE PATENTSCHRIFT

(11) **EP 1 380 050 B1**
(45) Veröffentlichungstag und Bekanntmachung des Hinweises auf die Patenterteilung: **01.10.2008**
(21) Anmeldenummer: 02732388.0
(22) Anmeldetag: 04.04.2002
(51) Int. Cl.: H01L 21/66

(54) **VERFAHREN ZUR HERSTELLUNG EINER CHALKOGENID-HALBLEITERSCHICHT DES TYPS ABC2 MIT OPTISCHER PROZESSKONTROLLE**
METHOD FOR PRODUCING A CHALCOGENIDE-SEMICONDUCTOR LAYER OF THE ABC2 TYPE WITH OPTICAL PROCESS MONITORING
PROCEDE DE PRODUCTION D'UNE COUCHE SEMICONDUCTRIQUE DE CHALCOGENURE DU TYPE ABC2 AVEC CONTROLE OPTIQUE DE PROCESSUS

(30) Priorität: 12.04.2001 DE 10119463
(43) Veröffentlichungstag der Anmeldung: 14.01.2004
(73) Patentinhaber: Helmholtz-Zentrum Berlin für Materialien und Energie GmbH, 14109 Berlin (DE)
(72) Erfinder: SCHEER, Roland, 10965 Berlin (DE); PIETZKER, Christian, 15827 Blankenfelde (DE)
(74) Vertreter: Rudolph, Margit
(86) Internationale Anmeldenummer: PCT/DE2002/001342
(87) Internationale Veröffentlichungsnummer: WO 2002/084729

(56) Entgegenhaltungen:
- US-A- 5 725 671
- NEGAMI ET AL: "Real time composition monitoring methods in pvd of Cu(In,Ga)Se2 thin films" , THIN FILMS FOR PHOTOVOLTAIC AND RELATED DEVICE APPLICATIONS. SYMPOSIUM, THIN FILMS FOR PHOTOVOLTAIC AND RELATED DEVICE APPLICATIONS. SYMPOSIUM, SAN FRANCISCO, CA, USA, 8-11 APRIL 1996 , 1996, PITTSBURGH, PA, USA, MATER. RES. SOC, USA, PAGE(S) 267 - 278 XP009003530 Seite 274; Abbildung 8

## Beschreibung

Die Erfindung bezieht sich auf ein Verfahren zur Herstellung einer Chalkogenid-Halbleiterschicht des Typs ABC₂ mit optischer Prozesskontrolle, wobei während der Herstellung die entstehende Schicht mit Licht bestrahlt, das von dieser Schicht reflektierte Licht detektiert und das aufgenommene Lichtsignal charakteristischen Punkten der Schichtherstellung zugeordnet wird.

Aus US-PS 5,725,671 ist eine Vorrichtung zur Herstellung einer ABC₂-Chalkopyrit-Dünnschicht bekannt, die neben einem Substrathalter und Mitteln zur Bereitstellung der Elemente A (Cu oder Ag), B (In, Ga oder AI) und C (S, Se oder Te) auch Mittel zur Überwachung/Darstellung der physikalischen Eigenschaften der entstehenden Schicht in Abhängigkeit von der Zeit aufweisen. Bei der Herstellung der Chalkopyrit-Dünnschicht des Typs ABC₂ werden in einem ersten Schritt gleichzeitig auf ein Substrat die Materialien A, B und C zu aufgebracht und in einem zweiten Schritt reagiert entweder ein Gas mit den Elementen B und C oder ein Gas mit den Elementen A, B und C, wobei B hier im Überschuss vorhanden ist, mit der im ersten Schritt aufgebrachten dünnen Schicht. Gleichzeitig wird nun eine optische Prozesskontrolle durchgeführt, um den Endpunkt des zweiten Schrittes über eine spezifische Änderung der physikalischen Eigenschaften der entstehenden Schicht zu bestimmen. Hierzu wird (u.a.) die entstehende Chalkopyritschicht mit IR-Licht bestrahlt und das von der Oberfläche dieser Schicht reflektierte Licht in Abhängigkeit von der Zeit gemessen. Der Endpunkt des Herstellungsprozesses ergibt sich aus dem zeitlichen Abstand von 5 bis 15 min nach der letzten abrupten Änderung des Signals. Eine Möglichkeit den Endpunkt des Herstellungsprozesses direkt aus einer Signatur des gemessenen Lichtes-abzuleiten, ist jedoch nicht gegeben.

Dem Stand der Technik nach allgemein bekannt ist auch die Herstellung von polykristallinen Chalkogenid-Halbleiterschichten mittels einer Chalkogenisierung von einzeln/nacheinander aufgebrachten metallischen Vorläuferschichten (z.B. beschrieben in Thin Film Cells and Technologies; 2nd WORLD CONFERENCE AND EXHIBITION ON PHOTOVOLTAIC SOLAR ENERGY CONVERSION 6-10 JULY 1993 VIENNA, AUSTRIA, pp. 537- 540). Der Prozess der Sulfurisierung/Chalkogenisierung findet in einem Lampenofen oder in einem thermisch beheizten Ofen statt und kann in sehr kurzer Zeit erfolgen. Technologisch bedingte Variationen der Eigenschaften der Precursorschichten und der Prozessparameter können zu Abweichungen im Prozessablauf führen und machen in den meisten Fällen Änderungen in dessen Ablauf notwendig. Eine Möglichkeit, diesen zuletzt erwähnten Prozess in Abhängigkeit der physikalischen Eigenschaften der sich zu bildenden Chalkogenidschicht zu steuern, gibt es bisher nicht.

Deshalb ist es Aufgabe der Erfindung, ein Verfahren anzugeben, das eine Kontrolle des Chalkogenisierungsprozesses und dadurch eine Steuerung dieses Prozesses und die Bestimmung seines Endpunktes unabhängig von einer Zeitangabe ermöglicht.

Die Aufgabe wird für ein Verfahren der eingangs genannten Art erfindungsgemäß dadurch gelöst, dass die Chalkogenid-Halbleiterschicht hergestellt wird, indem zunächst nacheinander die beiden metallischen Precursorschichten aus den Elementen A und B aufgebracht werden und anschließend ein Chalkogenisierungsprozess mit gleichzeitiger optischer Prozesskontrolle durchgeführt wird, bei der die Schichtenfolge A B mit Licht mindestens einer kohärenten Lichtquelle bestrahlt und das an der Oberfläche diffus gestreute Licht detektiert und anschließend das in Abhängigkeit von der Zeit gemessene Streulichtsignal derart ausgewertet wird, dass
- einem Punkt 1, gekennzeichnet durch ein Signalmaximum, die Precursortransformation von der Phase AB₂ zu A₁₁B₉,
- einem Punkt II, gekennzeichnet durch eine rasch abfallende Signalintensität, die Oberflächenchalkogenisierung der entstandenen Schicht, wobei die Phase ABC₂ initiell gebildet wird,
- einem Punkt III, gekennzeichnet durch ein zweites Signalmaximum, (a) die vollständige Bildung von ABC₂ im Falle einer Precursorschicht ohne Überschuss an A oder (b) der vollständigen Phasenseparation von ABC₂ und der Fremdphase AₓC_{y} im Falle einer Precursorschicht mit Überschuss an A und
- einem Punkt IV, gekennzeichnet durch eine rasch abfallende Signalintensität, die Transformation einer Fremdphase AₓC_{y} zu der Fremdphase AC
zugeordnet wird.

Für die eingesetzten Precursormaterialien werden in der Erfindung für A die Elemente Cu oder Ag , für B die Elemente In oder Ga oder Al und für C S oder Se verwendet.

Bei Messung des Differenzsignals des Streulichts gebildet durch Substraktion der Amplituden zweier oder mehrerer Streulichtsignale aus der Bestrahlung der Schicht mit kohärenten Lichtquellen verschiedener Wellenlängen - wie in einer Ausführungsform der Erfindung vorgesehen - wird der Einfluss der Verschmutzung der optischen Wege des gestreuten Lichts verringert. Das Verfahren ist dann auch in Apparaturen einsetzbar, in denen der Verschmutzungsgrad relativ hoch ist.

Das erfindungsgemäße Verfahren wird angewendet auf die Herstellung polykristalliner Chalkogenid-Halbleiterschichten mittels Chalkogenisierung von metallischen Vorläuferschichten. Die Herstellung findet in einem Lampenofen oder in einem thermisch beheizten Ofen statt und kann in sehr kurzer Zeit erfolgen.

Zwar wird in J. Vac. Sci. Technol. A 11 (4), Jul./Aug. 1993, pp. 1792-1795 über die Methode der diffusen Laserlichtstreuung berichtet, die hier zu Bestimmung der physikalischen Eigenschaften während des Reinigungsprozesses von GaAs und des nachfolgenden ZnSe/GaAs-Heteroepitaxieprozesses eingesetzt wird, jedoch konnten in dieser Arbeit dem Verlauf des optischen Signals weder Phasenübergänge zugeordnet noch der Endpunkt eines Prozesses - angezeigt durch Maxima oder rasch abfallende Signalintensitäten im zeitlichen Verlauf des Signals - bestimmt werden.

Während des oben beschriebenen Herstellungsprozesses der Chalkogenid-Halbleiterschicht erfolgen in zeitlich kurzer Folge strukturelle und morphologische Modifikationen der Schicht. Überraschenderweise sind bei der Messung des Streulichtsignals in Abhängigkeit von der Zeit während des Chalkogenisierungsprozesses in der aufgezeichneten Kurve charakteristische Punkte zu erkennen, deren Bestimmung/Auswertung sowohl der Qualitätskontrolle der Vorläuferschicht (aus deren Morphologie) als auch der Prozesskontrolle (aus der Änderung der Schichtmorphologie und der optischen Eigenschaften der Schicht während der Chalkogenisierung) und der zeitgenauen Endpunktbestimmung des Prozesses (aufgrund der Ausscheidung einer Fremdphase für eine Precursorschicht mit einem Überschuss an A oder aufgrund des Abschlusses der vollständigen Chalkogenisierung für eine Precursorschicht ohne Überschuss an A) dient.

Erst die Kenntnis über die Zusammenhänge zwischen Änderung der Schichtmorphologie und der Änderung der Phasen, Phasenausscheidungen während des Chalkogenisierungsprozesses und dem Verlauf des Streulichtsignals machen eine gezielte Beeinflussung dieses Prozesses möglich.

Die Erfindung wird in folgendem Ausführungsbeispiel anhand von Zeichnungen näher erläutert.

Dabei zeigen
- Fig. 1: eine schematische Darstellung des Chalkogenisierungsprozesses mit optischer Prozesskontrolle,
- Fig.2: die gemessene Kurve des Streulichtsignals als Funktion der Zeit (untere Kurve) und der entsprechende Verlauf der Substrattemperatur (obere Kurve).

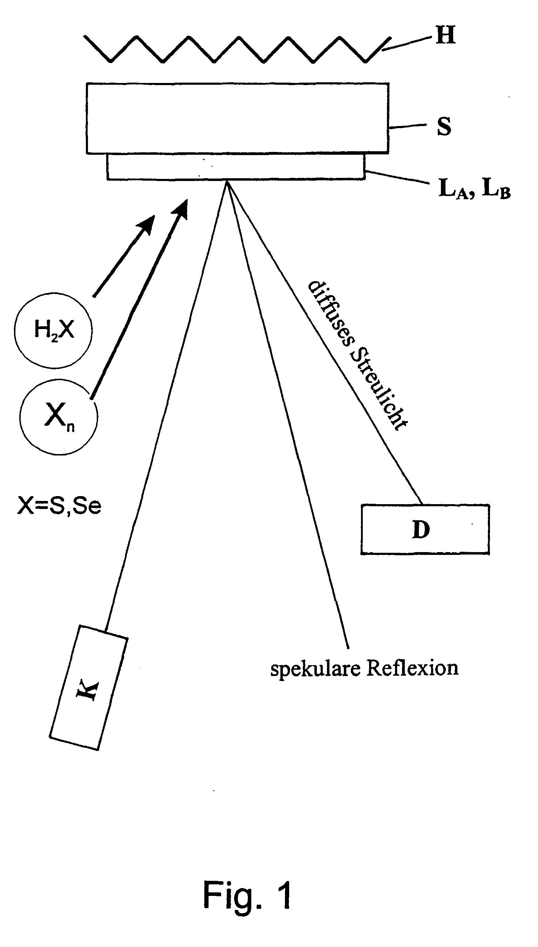

Die schematische Darstellung des Chalkogenisierungsprozesses von metallischen Vorläuferschichten in Fig. 1 zeigt ein Substrat **S**, auf dem die metallischen Vorläuferschichten **L_{A}** und **L_{B}** aufgebracht sind. Unter Erwärmung des Substrats S mittels der Heizung **H** werden Chalkogenspezies, beispielsweise S oder Se, (als Element oder in Wasserstoff-Verbindungen) auf die Vorläuferschichten **L_{A}** und **L_{B}** gelenkt, die die Chalkogenisierung bewirken. Das Licht einer kohärenten Lichtquelle **K** wird gleichzeitig auf diese Vorläuferschichten **L_{A}** und **L_{B}** gerichtet, dort an der Oberfläche diffus gestreut und das diffuse Streulicht mittels eines Detektors **D** aufgezeichnet.

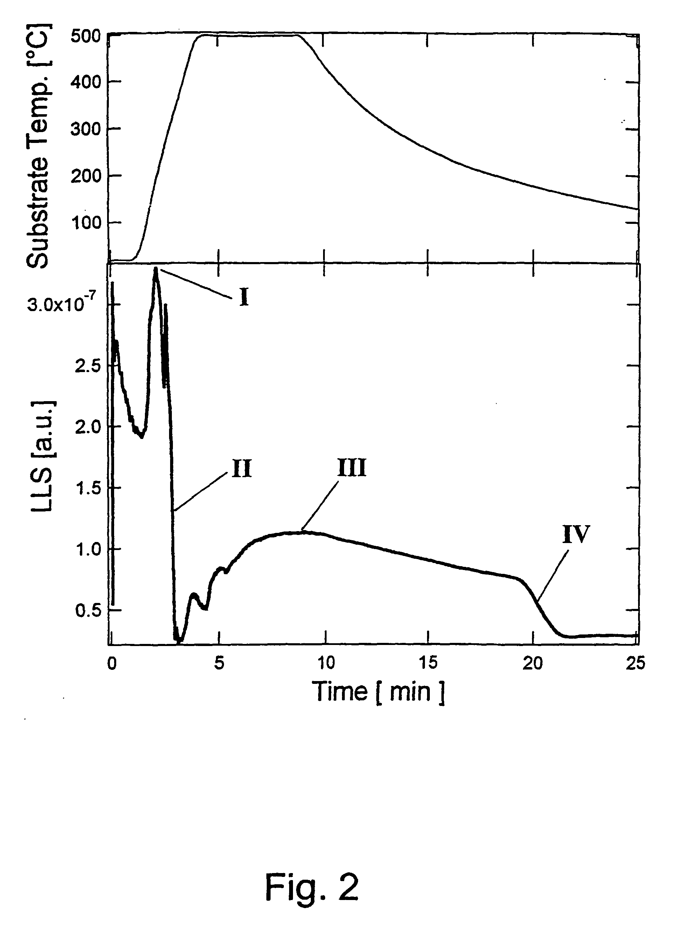

In Fig. 2 ist nun sowohl der Verlauf einer solchen Streulicht-Signalkurve **LLS** (untere Kurve) als auch der der Substrattemperatur (obere Kurve) in Abhängigkeit von der Zeit zum Vergleich gezeigt. Deutlich erkennbar sind charakteristische Punkte im Verlauf der Streulicht-Transiente **LLS**, die zur Prozess- und Qualitätskontrolle genutzt werden können.

Im folgenden werden die signifikanten Punkte in der Fig. 2 für das Beispiel der Sulfurisierung einer Culn Precursorschicht beschrieben. Die unerwartet eindeutige Zuordnung der Punkte konnte durch simultan durchgeführte in-situ Röntgenbeugungsmessungen eindeutig belegt werden. Der Punkt I, gekennzeichnet durch ein Maximum in der Signalintensität, wird hervorgerufen durch einen Phasenübergang Culn₂ zu Cu₁₁B₉. Sein Auftreten kann zur Precursor-Qualitätskontrolle herangezogen werden. Bleibt das Maximum aus, so ist die Precursorschicht fehlerhaft oder bereits thermisch vorbehandelt. Tritt der Punkt **I** z.B. bei einer zu hohen Temperatur auf, so zeigt dies Abweichungen von der nominellen Heizrate an. Somit ist die Detektion des Punktes ebenso geeignet für eine Prozesskontrolle.

Der Punkt **II**, gekennzeichnet durch eine rasch abfallende Signalintensität zu niedrigeren Intensitätswerten, wird hervorgerufen durch die Bildung von oberflächlichem CulnS₂. Tritt der Punkt I z.B. bei einer zu hohen Temperatur auf, so ist die Precursorschicht fehlerhaft oder die Heizrate zu niedrig. Somit ist die Detektion des Punktes geeignet für eine Prozesskontrolle.

Der Punkt **III**, gekennzeichnet durch ein zweites Maximum in der Signalintensität, wird hervorgerufen durch (a) den Abschluss der Bildung von CulnS₂ bei Precursorschichten ohne einem Überschuss von Cu und (b) durch den Abschluss Phasentrennung von CulnS₂ und CuₓS_{y}. Das Erreichen des Punktes III kann zur Prozesssteuerung herangezogen werden, indem bei Erreichen des Punktes III der Prozess durch Erniedrigung der Heizleistung beendet wird.

Der Punkt **IV**, gekennzeichnet durch eine rasch abfallende Signalintensität zu niedrigeren Intensitätswerten, wird hervorgerufen durch die Transformation der Phase CuₓS_{y} zu CuS. Aus der Höhe der Signaldifferenz bezogen auf den Wert vor und nach dem raschen Abfall kann der Überschuss von Cu in der Precursorschicht bestimmt werden. Somit ist die Detektion des Punktes IV für eine Qualitätskontrolle der Precursorschicht geeignet.

## Patentansprüche

1. Verfahren zur Herstellung einer Chalkogenid-Halbleiterschicht des Typs ABC₂ mit optischer Prozesskontrolle, wobei während der Herstellung die entstehende Schicht mit Licht bestrahlt, das reflektierte Licht detektiert und das in Abhängigkeit von der Zeit aufgenommene Lichtsignal charakteristischen Punkten der Schichtherstellung zugeordnet wird,
**dadurch gekennzeichnet, dass**
die Chalkogenid-Halbleiterschicht hergestellt wird, indem zunächst nacheinander die beiden metallischen Precursorschichten aus den Elementen A und B aufgebracht werden und anschließend ein Chalkogenisierungsprozess mit gleichzeitiger optischer Prozesskontrolle durchgeführt wird, bei der die Schichtenfolge A B mit Licht mindestens einer kohärenten Lichtquelle bestrahlt, das an der Oberfläche diffus gestreute Licht detektiert und das in Abhängigkeit von der Zeit gemessene Streulichtsignal derart ausgewertet wird, dass
• einem Punkt I die Precursortransformation von der Verbindung AB₂ zu A₁₁B₉,
• einem Punkt II die Oberflächenchalkogenisierung der entstandenen Schicht, wobei die Phase ABC₂ initiell gebildet wird,
• einem Punkt III die vollständige Bildung von ABC₂ im Falle einer Precursorschicht ohne einem Überschuss an A oder der vollständigen Phasenseparation von ABC₂ und der Fremdphase AₓC_{y} im Falle einer Precursorschicht mit einem Überschuss an A und
• einem Punkt IV die Transformation der Fremdphase AₓC_{y} zu der Fremdphase AC
zugeordnet wird.

2. Verfahren nach Anspruch 1,
**dadurch gekennzeichnet, dass**
als Precursormaterial A Cu oder Ag, als Precursormaterial B In oder Ga oder Al und als Material C S oder Se verwendet wird.

3. Verfahren nach Anspruch 1,
**dadurch gekennzeichnet, dass**
das Streulicht in Abhängigkeit von der Zeit als Differenzsignal gebildet durch Substraktion der Amplituden zweier oder mehrerer Streulichtsignale aus der Bestrahlung der Schicht mit kohärenten Lichtquellen verschiedener Wellenlängen gemessen wird.

## Claims

1. A method for producing a chalcogenide semiconductor layer of the ABC₂ type with optical process monitoring, the resultant layer being irradiated with light during production, the reflected light being detected and the light signal recorded as a function of time being assigned to characteristic points in layer production,
**characterised in that**
the chalcogenide semiconductor layer is produced by initially applying in succession the two metallic precursor layers of elements A and B and subsequently performing a chalcogenisation process with simultaneous optical process monitoring, in which the layer sequence A B is irradiated with light from at least one coherent light source, the light diffusely scattered on the surface is detected and the scattered light signal measured as a function of time is evaluated in such a manner that
• precursor transformation from compound AB₂ into A₁₁B₉ is assigned to a point I,
• surface chalcogenisation of the resultant layer, phase ABC₂ initially being formed, is assigned to a point II,
• complete formation of ABC₂ in the case of a precursor layer without an excess of A or complete phase separation of ABC₂ and the foreign phase AₓC_{y} in the case of a precursor layer with an excess of A is assigned to a point III and
• transformation of the foreign phase AₓC_{y} into the foreign phase AC is assigned to a point IV.

2. A method according to claim 1,
**characterised in that**
Cu or Ag is used as precursor material A, In or Ga or Al is used as precursor material B and S or Se is used as material C.

3. A method according to claim 1,
**characterised in that**
the scattered light is measured as a function of time as a differential signal formed by subtracting the amplitudes of two or more scattered light signals from irradiation of the layer with coherent light sources of different wavelengths.

## Revendications

1. Procédé de fabrication d'une couche semi-conductrice en chalcogénure du type ABC₂ avec contrôle optique du procédé selon lequel, au cours de la fabrication, on éclaire la couche formée, avec de la lumière, on détecte la lumière réfléchie et on associe le signal lumineux enregistré en fonction du temps à des points caractéristiques de la fabrication de la couche,
**caractérisé en ce qu'**
on fabrique la couche semi-conductrice de chalcogénure en appliquant tout d'abord successivement les deux couches métalliques de précurseur formées des éléments A et B et ensuite, on effectue un procédé de chalcogénurisation avec contrôle optique simultané du procédé, selon lequel on éclaire la succession de couches A B avec la lumière d'au moins une source lumineuse cohérente, on détecte la lumière diffuse difractée par la surface supérieure et on exploite le signal de lumière difractée, mesuré en fonction du temps **en ce que**
• au point I, on associe la transformation de précurseur de la combinaison AB₂ à la combinaison A₁₁B₉,
• au point II, on associe la chalcogénurisation de surface de la couche formée, la phase ABC₂ étant formée initialement,
• au point III, on associe la formation complète de ABC₂ dans le cas d'une couche de précurseur sans excédent A ou de la séparation de phase totale de ABC₂ et de la phase étrangère AₓC_{y} dans le cas d'une couche de précurseur ayant un excédent en A, et
• au point IV, on associe la transformation de la phase étrangère Aₓ-Cy à la phase étrangère AC.

2. Procédé selon la revendication 1,
**caractérisé en ce que**
comme matériau précurseur A, on utilise Cu ou Ag et comme matériau précurseur B, on utilise In ou Ga ou A1, et comme matériau C, on utilise S ou Se.

3. Procédé selon la revendication 1,
**caractérisé en ce qu'**
on mesure la lumière diffractée en fonction du temps en formant le signal de différence par soustraction de l'amplitude de deux ou plusieurs signaux de lumière diffractée provenant de l'éclairage de la couche avec des sources de lumière cohérente de différentes longueurs d'onde.
